(19) Europäisches Patentamt
European Patent Office
Office européen des brevets

(11) **EP 1 157 869 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**23.05.2012 Patentblatt 2012/21**

(51) Int Cl.:
*B60H 1/22* *(2006.01)*    *H05B 1/02* *(2006.01)*
*H05B 3/22* *(2006.01)*    *H05B 3/50* *(2006.01)*

(45) Hinweis auf die Patenterteilung:
**14.05.2003 Patentblatt 2003/20**

(21) Anmeldenummer: **00112395.9**

(22) Anmeldetag: **09.06.2000**

(54) **Elektrische Zusatzheizung für Kraftfahrzeuge**

Additional electrical heating device for vehicles

Chauffage électrique supplémentaire pour véhicules

(84) Benannte Vertragsstaaten:
**AT BE CH CY DE DK ES FI FR GB GR IE IT LI LU MC NL PT SE**
Benannte Erstreckungsstaaten:
**SI**

(30) Priorität: **23.05.2000 EP 00111120**

(43) Veröffentlichungstag der Anmeldung:
**28.11.2001 Patentblatt 2001/48**

(73) Patentinhaber: **Catem GmbH & Co.KG
76863 Herxheim bei Landau/Pfalz (DE)**

(72) Erfinder:
• **Beetz, Klaus, Dr.
76149 Karlsruhe (DE)**
• **Bohlender, Franz
76870 Kandel/Pfalz (DE)**

(74) Vertreter: **Grünecker, Kinkeldey,
Stockmair & Schwanhäusser
Leopoldstrasse 4
80802 München (DE)**

(56) Entgegenhaltungen:
EP-A- 0 901 311      DE-A- 3 509 073
DE-A1- 19 838 248    DE-A1- 19 845 401

EP 1 157 869 B2

**Beschreibung**

Die Erfindung betrifft eine elektrische Zusatzheizung für Kraftfahrzeuge gemäß dem Oberbegriff des Patentanspruchs 1.

Elektrische Heizungen werden in Kraftfahrzeugen beispielsweise zur Erwärmung der Innenraumluft, zur Vorheizung von Kühlwasser bei wassergekühlten Motoren oder Erwärmung von Kraftstoff verwendet. Derartige Zusatzheizungen bestehen üblicherweise aus mindestens einer Heizstufe mit Heizelementen und einer Steuervorrichtung. Die Heizelemente sind in der Regel als elektrischer Heizwiderstand, insbesondere als PTC-Element ausgebildet. Die Heizung und die Steuereinheit können sowohl als getrennte Funktionseinheiten ausgebildet als auch zu einer Baueinheit zusammengefasst sein.

Nachteilig an einer getrennten Ausbildung ist, dass Verbindungsleitungen zwischen Heizung und Kontrolleinheit erforderlich sind, die zum Teil erhebliche Ströme zu leiten haben. Außerdem muss die in der Steuereinheit erzeugte Verlustleistung gesondert abgeführt werden.

Aus EP-A2-0 901 311 ist eine elektrische Heizeinrichtung für Kraftfahrzeuge bekannt. Die beschriebene Zusatzheizung umfasst mehrere zu einem Heizblock zusammengesetzte Heizelemente. Der Heizblock wird zusammen mit einer Steuervorrichtung zur Ansteuerung der Heizelemente in einem gemeinsamen Rahmen gehalten. Auf diese Weise bildet die Steuervorrichtung mit dem in dem Rahmen gehaltenen Heizblock eine bauliche Einheit. Die Steuervorrichtung umfasst eine Leistungselektronik mit elektronischen Schaltern, die Kühlkörper aufweisen.

EP-A2-0 837 381 beschreibt eine elektrische Heizung, bei der sowohl die Heizelemente als auch eine Steuereinrichtung in einer Baueinheit angeordnet sind. In diesem Dokument sind verschiedene Steuerungskonzepte für elektrische Zusatzheizungen beschrieben.

DE 198 45 401 beschreibt eine Heizung mit einer Mehrzahl von Heizelementen. Die Einstellung der Heizleistung erfolgt so, dass nur ein Heizwiderstand über eine PWM-Ansteuerung kontinuierlich regelbar ist, wohingegen alle anderen Heizelemente nur vollständig zu- oder abgeschaltet werden. Die Zu- bzw. Abschaltung von Heizwiderständen wird in Abhängigkeit von der angeforderten Heizleistung gesteuert. Das Taktverhältnis für die PWM-Ansteuerung des Heizwiderstandes erfolgt in Abhängigkeit von der Differenz zwischen der angeforderten Heizleistung und der von den anderen Heizwiderständen erbrachten Heizleistung.

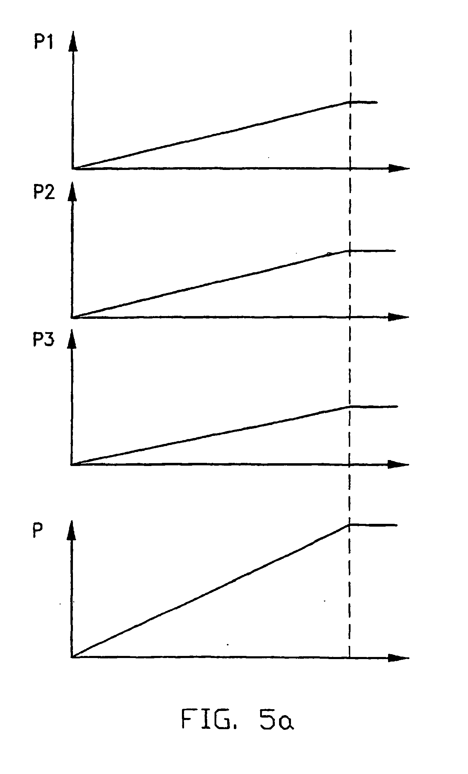

Die einfachste Leistungsregelung für eine Zusatzheizung aus mehreren einzelnen, voneinander getrennten Heizkreisen besteht aus einer gleichzeitigen Ansteuerung der Heizstufen. Eine solche Ansteuerung am Beispiel von drei Heizstufen ist in Fig. 5a dargestellt. Die Leistungen P1, P2 und P3 der einzelnen Heizstufen sind jeweils separat dargestellt. Bei steigendem Heizbedarf werden die Heizstufen gleichmäßig ausgesteuert, so dass jede der einzelnen Stufen eine zunehmend größere Heizleistung erbringt. Die Gesamtheizleistung P ist im untersten Diagramm der Fig. 5a dargestellt. Die Gesamtleistung P entspricht der Summe der Einzelheizleistungen P1 bis P3.

Eine solche Ansteuerung ermöglicht eine gleichmäßig verteilte Aufheizung der gesamten Zusatzheizung. Nachteilig an einer solchen Leistungsregelung ist jedoch, dass in der Steuervorrichtung für alle Heizstufen gleichzeitig eine hohe Verlustleistung entsteht.

Die Verlustleistung, die in der Steuerungsvorrichtung entsteht, kann dann vermindert werden, wenn die von jedem Heizkreis bzw. Heizelement abzugebende Leistung separat einstellbar ist Dazu werden die einzelnen Heizstufen unabhängig voneinander angesteuert und bei steigendem Heizbedarf sequentiell aufgeregelt.

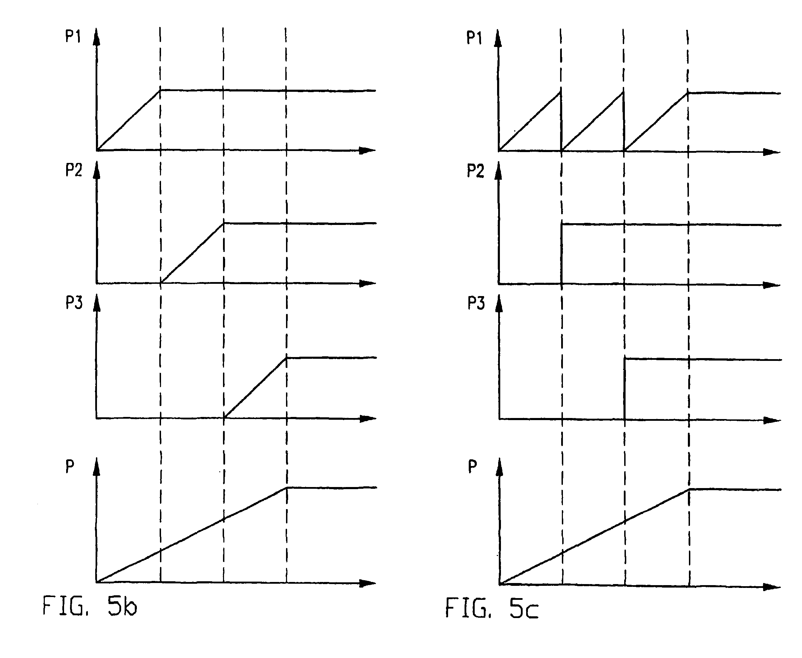

Wie in Fig. 5b dargestellt, werden bis auf eine Heizstufe alle anderen entweder mit Nulllast oder mit Volllast betrieben. Bei geringem Heizbedarf wird zunächst eine erste Heizstufe bis zum Volllastbetrieb aufgeregelt. Bei weiter steigendem Heizbedarf wird zusätzlich eine zweite Heizstufe aufgeregelt. Anschließend kann auch noch die dritte Heizstufe aufgeregelt werden, bis alle Heizstufen mit voller Heizleistung betrieben werden. Die Gesamtheizleistung P steigt dabei, wie im untersten Diagramm in Fig. 5b dargestellt, in derselben Weise, wie bei der gleichzeitigen Ansteuerung der Heizstufen gem. Fig. 5a, an.

Vorteilhaft an dieser Leistungsregelung ist, dass nur jeweils die nicht im Volllastbetrieb befindliche Heizstufe eine höhere Verlustleistung erzeugt, während die anderen Heizstufen nur eine geringe Verlustleistung verursachen.

Aufgabe der Erfindung ist es, eine weiter verbesserte Zusatzheizung anzugeben.

Diese Aufgabe wird mit den Merkmalen des Patentanspruchs 1 gelöst.

Bei der erfindungsgemäßen Zusatzheizung wird die Heizleistung dadurch variiert, dass der Strom, der jeweils durch Heizelemente fließt, mit einer Puls-Breiten-Modulation moduliert ist. Eine solche Leistungsregelung hat den Vorteil, dass sich die Verlustleistung besonders effektiv vermindern lässt. Die Heizleistung ergibt sich aus dem Tastverhältnis, mit dem der Strom jeweils getaktet wird. Das Tastverhältnis ist zur Anpassung an eine jeweils angeforderte Heizleistung variabel. Dadurch lässt sich eine stufenlose Leistungsregelung der Zusatzheizung erreichen. Die Gleichmäßigkeit der Wärmeerzeugung durch die Heizelemente wird dadurch verbessert, dass eine Ansteuerung der Heizstufen zeitlich voneinander versetzt erfolgt. Dabei variiert die Umschaltung zwischen Nulllast- und Volllastbetrieb benachbarter Heizstufen zeitlich. Der zeitliche Versatz wird dabei so gesteuert, dass der insgesamt entnommene Strom möglichst konstant bleibt, um eine möglichst gleichmäßige Belastung der Energieversorgung zu bewirken, beispielsweise im Bordnetz eines Autos.

Da jede Heizstufe von der Puls-Breiten-Modulation nur zwischen Nulllast- und Volllastbetrieb umgeschaltet wird, kann die von der Steuervorrichtung erzeugte Verlustleistung wirksam reduziert werden.

In einer vorteilhaften Ausgestaltung der Erfindung ist jeweils nur eine Heizstufe mit dem Maximalstrom getaktet, während die verbleibenden Heizstufen je nach Bedarf zu- bzw. abschaltbar sind. Eine solche Leistungsregelung, bei der eine stufenlose Leistungsregelung durch den getakteten Maximalstrom nur einer einzelnen Stufe bestimmt wird, hat eine insgesamt geringe Verlustleistung und zudem noch einen einfachen Aufbau. Eine Taktung ist nämlich nur für eine der Heizstufen erforderlich.

Um eine größere Homogenität der Wärmeerzeugung bei nebeneinander angeordneten Heizelementen zu erreichen, werden vorteilhafterweise alle Heizstufen getaktet.

Die Gleichmäßigkeit der Wärmeerzeugung durch die Heizelemente kann dadurch weiter verbessert werden, dass eine Taktung der Heizstufen zeitlich voneinander versetzt erfolgt. Dabei variiert die Umschaltung zwischen Nulllast- und Volllastbetrieb benachbarter Heizstufen zeitlich.

Belastungsspitzen lassen sich weiter dann vermeiden, wenn die Heizstufen nicht synchron getaktet werden, sondern zu einem Zeitpunkt jeweils nur eine der Heizstufen durch die Taktung zu- oder abgeschaltet wird.

Vorteilhafte Ausgestaltungen der Erfindung sind Gegenstand der Unteransprüche.

Die Erfindung wird im folgenden anhand der beiliegenden Figuren beschrieben, in denen:

Fig. 1a und 1b eine Aufsicht bzw. Seitenansicht einer erfindungsgemäßen elektrischen Zusatzheizung zeigen,

Fig. 2 die Grundschaltung einer erfindungsgemäßen elektrischen Schaltvorrichtung mit drei elektrischen Heizelementen zeigt,

Fig. 3 eine Detailansicht des kastenförmig ausgebildeten Seitenholms und der in diesen einsetzbaren Steuervorrichtung zeigt,

Fig. 4 eine weitere Detailansicht des kastenförmig ausgebildeten Seitenholms und der in diesen einsetzbaren Steuervorrichtung zeigt,

Fig. 5a, 5b und 5c unterschiedliche Steuerungskonzepte für die Ansteuerung von drei Heizelementen bei zunehmender Heizleistung zeigen,

Fig. 6a und 6b Beispiele für eine getaktete Steuerung der Heizleistung angeben,

Fig. 7a und 7b Beispiele für eine zeitversetzte Ansteuerung wiedergeben, und

Fig. 8 ein Beispiel für eine Modulation mit einer alternativen Kurvenformen zeigt.

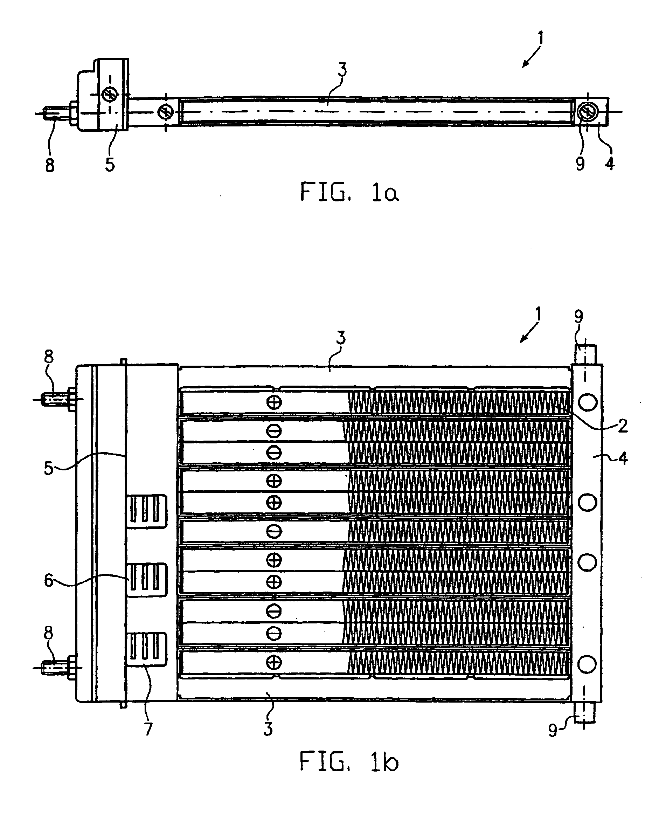

In Fig. 1a ist eine Seitenansicht der erfindungsgemäßen elektrischen Zusatzheizung 1 gezeigt, die insbesondere für den Einsatz in Kraftfahrzeugen geeignet ist. Fig. 1b zeigt eine Aufsicht auf die elektrische Zusatzheizung 1. Die elektrische Zusatzheizung 1 enthält einen Heizblock, der aus einer Mehrzahl geschichteter oder gestapelter Heizelemente 2 besteht. Jedes Heizelement 2 besteht aus einem Widerstandsheizelement und benachbart dazu angeordneten Radiatoren oder Wärmeleitblechen. Als Widerstandsheizelemente werden vorzugsweise PTC-Elemente verwendet. Der Heizblock aus den Heizelementen 2 wird in einem Rahmen gehalten. Dieser Rahmen besteht aus gegenüberliegenden Längsholmen 3 und senkrecht dazu angeordneten Seitenholmen 4 und 5. Die Holme des Rahmens werden entweder aus Metall oder aus Kunststoff gefertigt.

Während die Längsholme 3 im wesentliche symmetrisch aufgebaut sind, unterscheiden sich die beiden Seitenholme 4 und 5 in der in Fig. 1 dargestellten Ausführungsform.

Im Gegensatz zum Seitenholm 4 ist der Seitenholm 5 als einseitig offener Kasten ausgebildet. Die Öffnung dieses kastenförmigen Seitenholms 5 liegt auf der den Heizelementen 2 gegenüberliegenden Seite des Seitenholms 5. In diesen Kasten ist eine Steuervorrichtung einsetzbar, die die Wärmeabgabe der einzelnen Heizelemente 2 durch Steuerung des den Heizelementen 2 zugeführten Stromes steuert. Die offene Seite des als Kasten ausgebildeten Seitenholms 5 wird nach dem Einsetzen der Steuerschaltung mit einem aufsteckbaren oder aufklipsbaren Deckel verschlossen.

Die Platine 10 der Steuervorrichtung ist nach dem Einsetzen vorzugsweise senkrecht zur Rahmenebene angeordnet, es ist jedoch auch eine parallele Anordnung möglich (nicht dargestellt).

Die Zusatzheizung 1 wird über zwei Anschlussbolzen 8 mit Strom versorgt. Sie sind so ausgebildet, dass sie problemlos die geforderten Heizströme leiten können. Die Anschlussbolzen 8 ragen in der in Fig. 1 dargestellten Ausführungsform auf der Seite heraus, auf der der kastenförmige Seitenholm 5 offen ist.

Auf derselben Seite ist ein weiterer Steckersokkel zur Ansteuerung der Steuervorrichtung vorgesehen, der in Fig. 1 nicht dargestellt ist.

Der Seitenholm 5 weist auf den Seiten, die in der Flächenebene des Rahmens liegen, Fensteröffnungen 7 auf. Diese Fensteröffnungen sind so angeordnet, dass sie ebenfalls in dem zu erwärmenden Luftstrom liegen. Zwischen den sich gegenüberliegenden Fensteröffnungen 7 sind Kühlelemente 6 angeordnet, die zu den Leistungselektronikbauelementen der Steuerschaltung gehören. Beim Betrieb wird nicht nur der Heizblock aus den Heizelementen 2, sondern ebenfalls die Fensteröffnungen 7 von zu erwärmender Luft durchsetzt.

Die Wahl der Größe der Fensteröffnungen 7 erlaubt, den Anteil der Luftmenge zu bestimmen, die an den Kühlelementen 6 vorbeiströmt. Der Luftdurchsatz wird so eingestellt, dass die durch den Heizblock geströmte Luft und die an den Kühlkörpern 6 vorbeigeströmte Luft möglichst geringe Temperaturunterschiede aufweisen. Nur wenn die durch die Fensteröffnungen 7 geströmte Luft in ihrer Temperatur der durch den Heizblock geströmten Luft möglichst nahe kommt, wird eine möglichst hohe Effizienz beim Betrieb der Zusatzheizung erreicht.

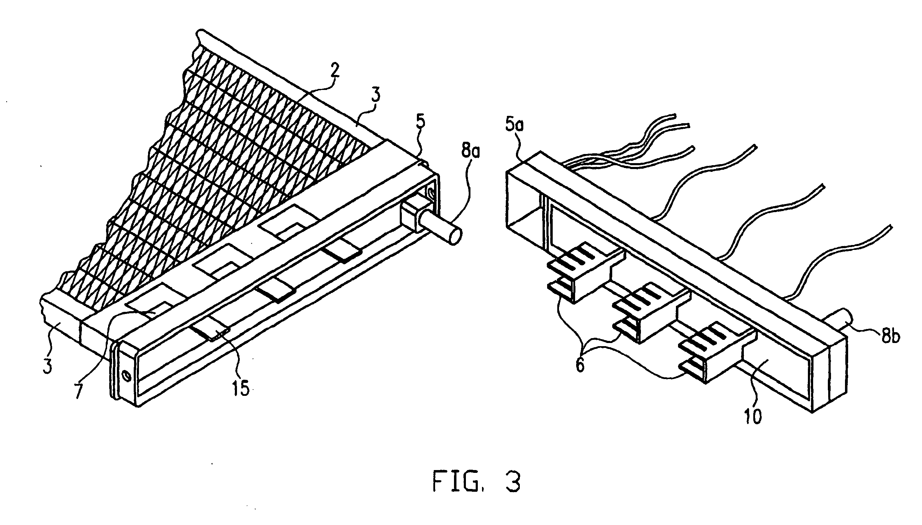

Figur 3 zeigt eine Detailansicht des kastenförmig ausgebildeten Seitenholms 5 und der in diesen einsetzbaren Steuerschaltung. Der Seitenholm 5 ist auf einer Seite mit den Längsholmen 3 und dem Heizblock mit den Heizelementen 2 verbunden. Auf der Oberseite des Seitenholms 5 sind die fensterförmigen Öffnungen 7 zu erkennen, durch die die zu erwärmende Luft hindurchtritt.

Innerhalb des kastenförmig ausgebildeten Seitenholms 5 sind drei Anschlusslaschen 15 zu erkennen und ein Anschlussbolzen 8a. Dieser Anschlussbolzen stellt die Plusverbindung für alle Heizelemente 2 dar. Zusätzlich ist in dieser Abbildung in perspektivischer Darstellung die Steuervorrichtung 5a zu erkennen, die in den Kasten des Seitenholmes 5 einsetzbar ist. Die Steuervorrichtung 5a wird mit der dem Seitenholm 5 zugewandten Seite in diesen eingesetzt.

Auf der dem Seitenholm 5 zugewandten Seite der Steuereinrichtung 5a ist die Unterseite der Platine 10 zu erkennen. Aus dieser Platine 10 ragen drei Kühlelemente 6 heraus. Jedes dieser Kühlelemente bzw. Kühlbleche ist einem der Leistungstransistoren 11 einer Heizstufe zugeordnet.

Zu jedem Kühlelement 6 sind entsprechende Fensteröffnungen 7 in der Oberfläche des Seitenholms 5 vorgesehen. Dadurch wird im Betrieb jedem Kühlelement gezielt ein Luftstrom zugeführt

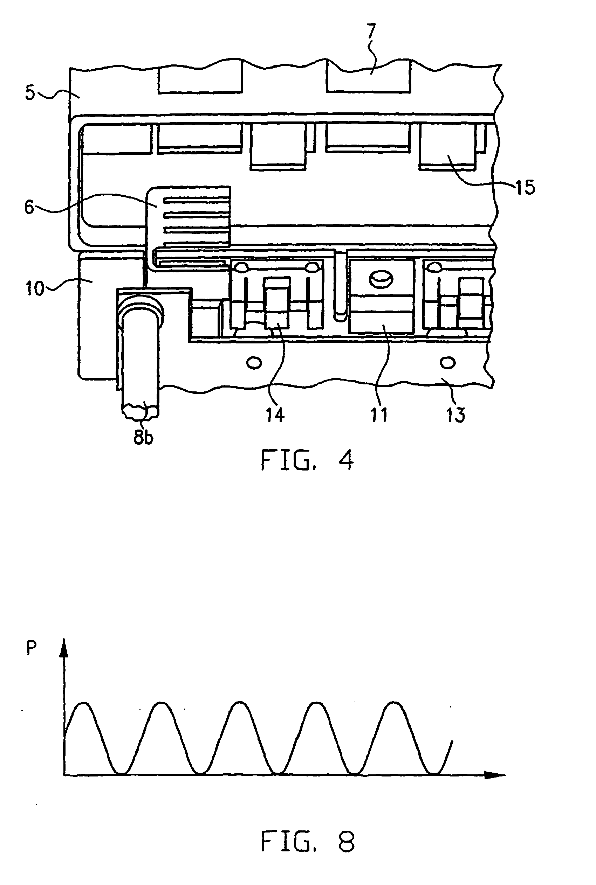

Auf der nach außen gewandten Seite ist ein weiterer Anschlussbolzen 8b zu erkennen. Dieser Anschlussbolzen dient als elektrischer Massepol bei der Zuführung von Strom. Der Anschlussbolzen 8b ist mit der in Fig. 4 dargestellten Leitungsschiene 13 verbunden, die den Heizstrom einzelnen Heizstufen zuführt. Jeder einzelne der Heizstufen entnimmt über ihren Leistungstransistor 11 bis zu etwa 40 Ampere der über die Leitungsschiene 13 zugeführten Strommenge.

In Fig. 4 ist eine weitere perspektivische Detailansicht des Seitenholms 5 und der in die kastenförmige Öffnung des Seitenholms 5 einsteckbaren Steuerschaltung dargestellt.

Im oberen Bereich der Fig. 4 sind auf der Oberfläche des Seitenholms 5 zwei der Fensteröffnungen 7 zu erkennen. Diese Fensteröffnungen sind so angeordnet, dass sie ober- und unterhalb der Kühlelemente 6 liegen, wenn die Steuerschaltung in den Seitenholm 5 eingesetzt ist. Für eine gezielte Lenkung des Luftstroms zwischen den Fensteröffnungen 7 können in dem Seitenholm 5 zusätzliche Wände vorgesehen sein, die in den Figuren nicht dargestellt sind.

Innerhalb der kastenförmigen Öffnung des Seitenholms 5 sind die Anschlusslaschen 15 der Heizelemente 2 zu erkennen. Für jede Heizstufe ist eine Anschlusslasche 15 vorgesehen.

In der unteren Hälfte der Fig. 4 ist die in den Seitenholm 5 einsetzbare Steuerschaltung dargestellt. Nur einer der Leistungstransistoren 11 ist in diesem Fall zur besseren Deutlichkeit des Aufbaus mit einem Kühlelement 6 versehen.

Auf einer Platine 10 ist neben den Leistungselektronikbauelementen 11 eine Steuerelektronik vorgesehen. Die Steuerelektronik bestimmt die von den Leistungselektronikbauelementen 11, insbesondere den Leistungstransistoren, an das diesen jeweils zugeordnete Heizelement 2 abzugebende Strommenge. Die Strommenge wird der Steuerschaltung von einem der Anschlussbolzen 8 über eine Leitungsschiene 13 zugeführt. Der Ausgang des Leistungstransistors 11 ist fest mit der Platine 10 verlötet und mit dem diesem Transistor zugeordneten Federelement 14 verbunden.

Die Federelemente 14 sind so auf der Platine angebracht, dass sie beim Zusammenstecken der Steuervorrichtung in den Seitenholmen 5 mit den Anschlussfahnen 15 der Heizelemente 2 verbunden sind.

In der dargestellten Ausführungsform werden die Anschlussfahnen 15 durch die Platine 10 hindurch in die Federelemente 14 gesteckt. Eine solche Anordnung erlaubt eine feste mechanische Fixierung der Platine 10 mit der Steuerelektronik in dem Rahmen. Gleichzeitig wird eine elektrische Kontaktierung mit den jeweiligen Heizelementen bewirkt.

Die Platine 10 ist nur einseitig mit Bauelementen bestückt. Entsprechend der Anzahl von Heizstufen weist die Platine waagerecht auf dieser befestigte Leistungstransistoren 11 auf. Im Ausführungsbeispiel sind drei Heizstufen und dementsprechend drei Leistungstransistoren vorgesehen. Jeder Leistungstransistor 11 ist an seinem Ausgangsanschluss fest mit der Platine 10 verlötet.

Aus dem Transistor ragt eine Anschlussfahne heraus, an der ein Kühlelement 6 befestigt ist. Das Kühlelement 6 ist vorteilhafterweise nicht elektrisch leitend mit dem Heizelement verbunden.

Das Kühlelement 6 weist Kühlrippen auf, die in einer Ebene liegen, die senkrecht auf der Platine steht Im gezeigten Ausführungsbeispiel sind die Kühlrippen zudem auf der nicht bestückten Seite der Platine angeordnet. Nur ein Schenkel des Kühlelementes 6 ragt auf die bestückte Seite der Platine und ist mit der Anschlussfahne des Transistors 11 verbunden, um die vom Transistor erzeugte Wärme abzuleiten. In der gezeigten Ausführungsform ragt der mit dem Transistor 11 verbundene Schenkel des Kühlelementes 6 durch eine Öffnung in der Platine 10 auf die bestückte Seite der Platine 10. Diese Öffnungen in Fig. 4 jeweils links von den Transistoren 11 angeordnet zu erkennen. Er kann jedoch ebenfalls über den Rand der Platine ragen, so dass eine Öffnung in der Platine 10 nicht erforderlich ist.

Eine entsprechende Anordnung der Bauelemente von Transistor 11, Federelement 14 und Kühlelement 6 ist jeweils für jede Heizstufe auf der Platine vorgesehen.

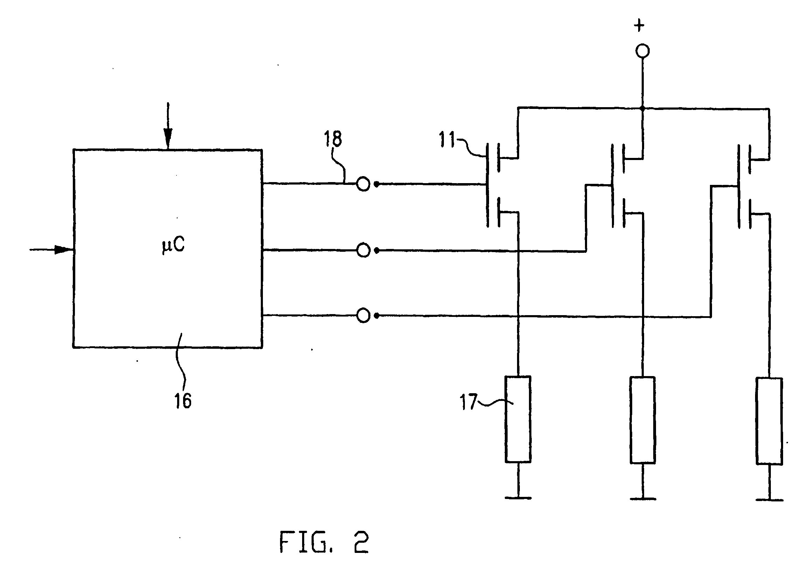

Die Grundschaltung einer elektrischen Heizvorrichtung als Zusatzheizung gemäß der vorliegenden Erfindung ist in Fig. 2 dargestellt. Eine Recheneinheit 16, vorzugsweise ein Mikrocomputer, steuert die Heizleistung mehrerer elektrischer Heizwiderstände 17. Die hohen Ströme, die zur Erzielung einer Gesamtheizleistung im Bereich von 1000 bis 2000 Watt erforderlich sind, werden über Leistungshalbleiter 11, insbesondere Leistungstransistoren, den elektrischen Heizwiderständen 17 zugeführt. Welche Strommenge von den Transistoren 11 an die Widerstände 17 geleitet wird, bestimmt die Steuervorrichtung 16 in Abhängigkeit von dem verwendeten Steuerverfahren und vorgegebenen Sollwerten. Dazu ist die Recheneinheit 16 über Leitungen 18 separat mit jedem der Leistungstransistoren 11 verbunden.

Die Gesamtheizleistung, die von den Heizwiderständen 17 erzeugt wird, regelt die Recheneinheit 16 in Abhängigkeit von der erwünschten Heizleistung. Zusätzlich kann auch die maximal zur Verfügung stehende Generatorleistung in einem Kraftfahrzeug bei der Steuerung mitberücksichtigt werden.

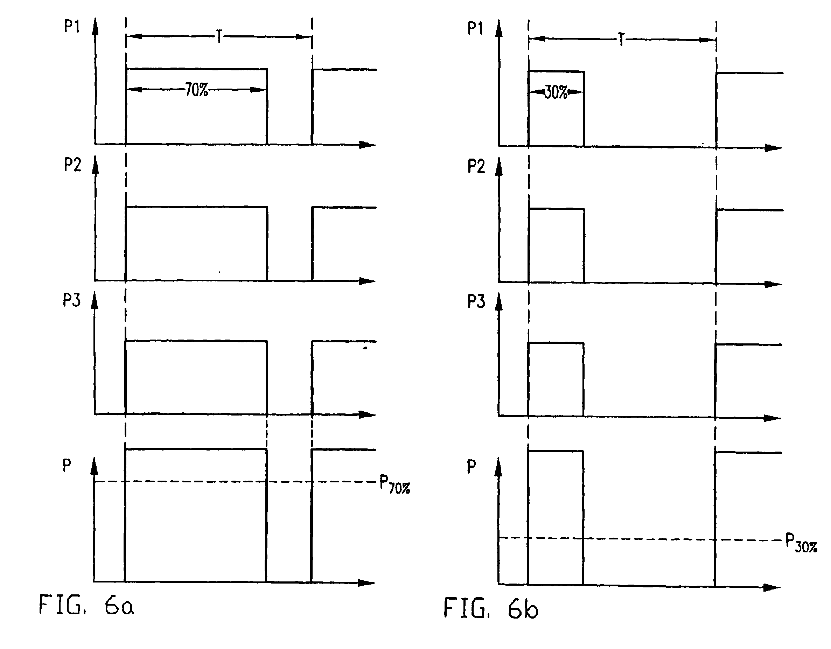

In welcher Weise jeder der einzelnen Heizwiderstände zur Gesamtheizleistung beiträgt, hängt von dem gewählten Leistungsregelungskonzept ab. Im Gegensatz zu bekannten, linearen Ansteuerungskonzepten wird erfindungsgemäß eine getaktete Ansteuerung verwendet. In den Fig. 6a und 6b sind Beispiele für eine getaktete Leistungsregelung wiedergegeben. Die Zusatzheizung besteht dabei wiederum vorzugsweise aus drei voneinander getrennten Heizkreisen mit elektrischen Heizwiderständen 17. Die Heizleistung jedes einzelnen Widerstands 17 ist mit P1, P2 und P3 angegeben. Die resultierende Gesamtheizleistung ergibt sich im untersten Diagramm jeweils zu P.

Jeder Heizkreis wird von der Steuereinrichtung 1 mit einer festen Frequenz f mit der Periode T getaktet. Die Leistung jedes einzelnen Heizelementes 17 ergibt sich dabei aus dem Tastverhältnis. Durch eine Modulation der Breite der Pulse ist es möglich, die Heizleistung stufenlos zu variieren. Die Trägheit der Heizelemente aus Heizwiderständen und Wärmeleitelementen (beispielsweise Radiatoren) bei der Wärmeleitung bewirkt eine der gemittelten Heizleistung entsprechende Temperatur. Die Schwankungen der Temperatur der Heizelemente sind daher im Vergleich zu denen der Ströme weit weniger stark.

Die in Fig. 6a gezeigte Leistungsregelung entspricht prinzipiell der unter Bezugnahme auf Fig. 5a beschriebenen linearen Aussteuerung. Demgemäss werden zur Erzeugung einer vorgegebenen Gesamtheizleistung alle Heizelemente gleichmäßig ausgesteuert. Bei zunehmender Gesamtheizleistung nimmt die Heizleistung aller einzelnen Heizelemente entsprechend zu.

In Fig. 6a ist beispielsweise ein Tastverhältnis von 70% für jeden der Impulse angegeben. Es wird also demgemäss 70% der maximal möglichen Heizleistung erzeugt Im untersten Diagramm gibt die gestrichelte Linie mit der Bezeichnung $P_{70\%}$ die gemittelte effektive Heizleistung aller Heizelemente an, während die durchgezogene Linie jeweils die Momentanleistung anzeigt. In Fig. 6b ist eine entsprechende Ansteuerung für eine 30%-ige Gesamtheizleistung wiedergegeben.

Eine zeitlich synchron erfolgende Tastung der verschiedenen Heizelemente führt jedoch bei jedem Taktvorgang zu einem sprunghaften Anstieg der von der Zusatzheizung entnommenen Generatorleistung bzw. zu einem ebenso sprunghaften Abfall. Diese Umschaltung zwischen Nulllast und Volllast mit jedem Takt führt zu einer unregelmäßigen und störenden Belastung des Generators. Dementsprechend pulsiert auch die von der Zusatzheizung insgesamt abgegebene Wärmemenge. Die starken Schwankungen der Momentangesamtleistung wird von den durchgezogenen Linien in den untersten Diagrammen in Fig. 6a und 6b wiedergegeben.

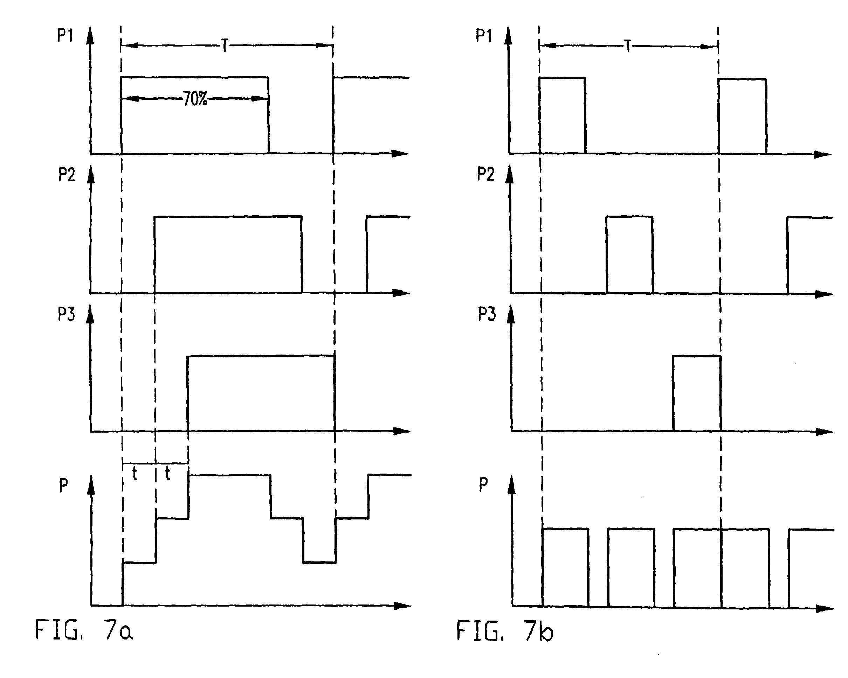

Um solche zeitlichen Schwankungen in der Wärmeabgabe zu vermeiden, werden bei Verwendung mehrerer Heizstufen diese vorzugsweise zeitlich versetzt getaktet. In Fig. 7a und 7b sind Beispiele für einen solchen zeitlichen Versatz dargestellt. Die drei Heizstufen werden mit einem zeitlichen Versatz t getaktet Dabei ist die jeweilige aktive Impulsbreite der einzelnen Heizstufen über eine ganze Periode T eines Taktes verteilt. Auf diese Weise wird die Gesamtheizleistung zeitlich sehr viel gleichmäßiger erzeugt. In Fig. 7a und 7b ist eine im Vergleich zu den Fig. 6a und 6b relativ konstante Momentan-Gesamtheizleistung im untersten Diagramm zu erkennen.

Die verschiedenen Heizkreise werden gemäß Fig. 7 sequentiell mit einem vorbestimmten zeitlichen Versatz innerhalb einer Frequenzperiode angesteuert. Auf diese Weise wird eine gleichzeitige Stromverdopplung und damit eine erhöhte Belastung für einen (Kraftfahrzeug)-Generator vermieden. Idealerweise erfolgt die Ansteuerung einer weiteren Heizstufe jeweils in den Strompausen der weiteren Heizstufen, wie in Fig. 7b gezeigt Ein gleichmäßiger Zeitversatz innerhalb einer Periode T ergibt sich bei einem Zeitversatz t gemäß folgender Formel

$$t = \frac{1 \cdot TV}{n-1}$$

wobei *TV* das Tastverhältnis angibt und *n* die Anzahl der verwendeten Heizstufen.

Dadurch, dass die aktiven Pulsbreiten über die gesamte Dauer einer Periode T verteilt werden, kann auch bei unterschiedlichen Tastverhältnissen eine möglichst kontinuierliche elektrische Belastung erzeugt werden. In Fig. 7b ist ein nahtloser Anschluss des Gesamtstroms im untersten Diagramm, das die Gesamtheizleistung P wiedergibt, beim Übergang vom letzten Impuls einer Periode T vom dritten Heizelement zu dem ersten Impuls einer neuen Periode T vom ersten Heizelement zu erkennen.

Bis zu einer Heizleistung von P/n jeder einzelnen Stufe können die "aktiven" Impulse der Einzelstufen so aufeinanderfolgen, dass ein nahezu konstanter Stromfluss entsteht und nur eine geringe Anzahl von Stromflusssprüngen erforderlich ist.

Im folgenden wird eine zweite Ausführungsform eines Leistungsregelungskonzepts beschrieben. Gemäß dem Stand der Technik ist es bekannt, mehrere, unabhängige Heizstufen je nach gewünschter Gesamtheizleistung gleichmäßig auszusteuern (vgl. Fig. 5a) oder jede Heizstufe sequentiell aufzuregeln (vgl. Fig. 5b). Beide bekannte Regelungskonzepte haben jedoch die folgenden Nachteile. Bei der gleichmäßigen Aufregelung aller Heizelemente (Fig. 5a) wird abhängig von der eingestellten Heizleistung jeweils eine relativ hohe Verlustleistung erzeugt. Gemäß der in Fig. 5b dargestellten sequentiellen Aufregelung separater Heizelemente wird die Verlustleistung vermindert, indem ein weiteres Heizelement erst dann aktiv wird, wenn ein Vorhergehendes die erwünschte Heizleistung nicht mehr allein bewirken kann.

Mit einem solchen Leistungsregelungskonzept wird zwar die Verlustleistung der Steuervorrichtung deutlich vermindert, jedoch der Steuerungsaufwand selbst erhöht.

Zudem benötigen beide bekannte Regelungskonzepte separate lineare Regler für jede Heizstufe.

Diese beiden Nachteile lassen sich vermeiden, in dem das in Fig. 5b dargestellte Regelungskonzept weiter verbessert wird. Dazu werden die Heizstufen bei steigendem Heizleistungsbedarf nicht aufeinanderfolgend hochgeregelt, sondern nur eine einzige Heizstufe ist regelbar ausgestaltet Alle weiteren zusätzlichen Heizstufen sind entweder nur unter Volllast oder Nulllast betreibbar. Diese Heizstufen können je nach Bedarf zu- bzw. abgeschaltet werden. Für eine entsprechende "Feinabstimmung" der zu erbringenden Heizleistung wird die regelbare Heizstufe mit einem variablen Beitrag zugeschaltet. Die Heizleistung dieser Heizstufe ist kontinuierlich einstellbar (in der Regel über eine Vielzahl diskreter Werte). Ein solches Regelungskonzept ist in Fig. 5c dargestellt.

Dieses Konzept lässt sich auch auf eine getaktete Aussteuerung übertragen. Dazu ist die Heizleistung einer Stufe kontinuierlich durch Einstellung des Tastverhältnisses TV regelbar. Weitere Heizstufen werden je nach Bedarf zu- bzw. abgeschaltet. Eine solche Regelung hat den Vorteil, dass nur eine Stufe getaktet wird und damit der Steuerungsaufwand vermindert wird. Stromverdopplungen, wie bei der ersten Ausführungsform können dabei nicht auftreten.

In Fig. 8 ist ein Beispiel für eine alternative Kurvenform dargestellt, um den Strom, der einem Heizelement jeweils zugeführt wird, zu modulieren. Anders als die Rechteckfunktionen der vorhergehenden Beispiele können auch Modulationsfunktionen mit weniger sprunghaftem Anstieg bzw. Abfall des Stromflusses verwendet werden. Als Beispiel ist in Fig. 8 eine sinusförmige Taktung wiedergegeben. Weitere, nicht dargestellte Funktionen sind ebenfalls möglich. Solche Kurven zeichnen sich dadurch aus, dass der Strom nicht nur zwischen einem Nulllast- und einem Volllastbetrieb umgeschaltet wird, sondern auch Zwischenwerte annimmt.

## Patentansprüche

1. Elektrische Zusatzheizung zur Erwärmung der Innenraumluft in Kraftfahrzeugen mit:

   mehreren zu einem Heizblock zusammengesetzten Heizelementen (2), wobei der Heizblock in einem rechteckigen Rahmen (3, 4, 5) gehalten ist und der Rahmen, in dem der Heizblock gehalten ist, aus sich gegenüberliegenden Längsholmen (3) und senkrecht zu diesen angeordneten Seitenholmen (4, 5) gebildet ist, und einer Steuervorrichtung (1) zur Ansteuerung der Heizelemente (2), die mit dem in dem Rahmen (3, 4, 5) gehaltenen Heizblock eine bauliche Einheit bildet, wobei die Heizleistung der Heizelemente (2) über den durch die Heizelemente (2) jeweils fliessenden Strom einstellbar ist und die Steuervorrichtung (1) Leistungstransistoren (11) zur Einstellung des durch die Heizelemente (2) jeweils fliessenden Stroms aufweist,
   **dadurch gekennzeichnet, dass**
   die Steuervorrichtung (1) zur Einstellung der Heizleistung den durch ein Heizelement (2) fliessenden Strom mit einer Puls-Breiten-Modulation moduliert,
   jeweils nur eines der Heizelemente (2) gleichzeitig mit einem entsprechenden Stromanstieg oder Stromabfall angesteuert wird,
   zumindest einer der Seitenholme (5) als einseitig offener Kasten ausgebildet ist, in den die Steuervorrichtung einsetzbar ist,
   Fensteröffnungen (7) in dem Seitenholm (5) auf den Seiten, die in der Flächenebene des Rahmens liegen, vorgesehen sind und so angeordnet sind, dass sie in dem zu erwärmenden Luftstrom liegen, und
   Kühlelemente (6) der Leistungstransistoren (11) bei eingesetzter Steuervorrichtung jeweils zwischen sich gegenüberliegenden Fensteröffnungen (7) liegen.

2. Elektrische Zusatzheizung nach Anspruch 1, **dadurch gekennzeichnet, dass** nur der Strom durch eines der Heizelementen (2) modulierbar ist und weitere Heizelemente (2) in Abhängigkeit von der einzustellenden Heizleistung jeweils zu- oder abschaltbar sind.

3. Elektrische Zusatzheizung nach Anspruch 1, **dadurch gekennzeichnet, dass** die durch die elektrischen Heizelemente (2) jeweils fließenden Ströme in Abhängigkeit von der einzustellenden Heizleistung modulierbar sind.

4. Elektrische Zusatzheizung nach Anspruch 3, **dadurch gekennzeichnet, dass** der Puls, der die durch die Heizelemente (2) fließenden Ströme moduliert, zeitlich jeweils versetzt ist, so dass der resultierende Gesamtstrom aus den durch die Heizelemente (2) fließenden Strömen möglichst konstant ist.

5. Elektrische Zusatzheizung nach Anspruch 3 oder 4, **dadurch gekennzeichnet, dass** der Puls für die Modulation der jeweiligen Ströme zeitlich so versetzt ist, dass jeweils nur eines der Heizelemente (2) gleichzeitig mit einem entsprechenden Pulsanstieg oder Pulsabfall ansteuerbar ist.

6. Elektrische Zusatzheizung nach Anspruch 1, **dadurch gekennzeichnet, dass** Mittel zur Beeinflussung der Luftströmung zwischen den sich gegenüberliegenden Fensteröffnungen (7) vorgesehen sind.

## Claims

1. Electric supplementary heater for heating the interior air in motor vehicles with:

   a plurality of heating elements (2) assembled to a heating block, wherein the heating block is held in a rectangular frame (3, 4, 5) and the frame in which the heating block is held is formed from opposite longitudinal bars (3) and lateral bars (4, 5) arranged vertical to these, and a control device (1) for driving the heating elements (2) which form a structural unit with the heating block held in the frame (3, 4, 5), wherein the heating capacity of the heating elements (2) can be adjusted via the current flowing through the heating elements (2) respectively and the control device (1) has power transistors (11) for adjusting the current flowing through the heating elements (2), respectively,
   **characterised in that**
   the control device (1) for adjusting the heating capacity modulates the current flowing through a heating element (2) with a pulse width modulation,
   in each case only one of the heating elements (2) is driven simultaneously with a corresponding increase in current or decrease in current,

   at least one of the side bars (5) is developed as a box open on one side into which the control device can be inserted,
   window openings (7) are provided in the side bar on the sides lying at the level of the frame and are arranged such that they lie in the air current to be heated and
   cooling elements (6) of the power transistors (11) with the control device inserted in each case lie between the opposite window openings (7).

2. Electric supplementary heater according to claim 1, **characterised in that** only the current through one of the heating elements (2) can be modulated and further heating elements (2) can in each case be switched on or off as a function of the heating capacity to be adjusted, respectively.

3. Electric supplementary heater according to claim 1, **characterised in that** the currents flowing through the electric heating elements (2) can be modulated as a function of the heating capacity to be adjusted, respectively.

4. Electric supplementary heater according to claim 3, **characterised in that** the pulse which modulates the currents flowing through the heating elements (2) is in each case chronologically staggered so that the resulting total current of the currents flowing through the heating elements (2) is as constant as possible.

5. Electric supplementary heater according to claim 3 or 4, **characterised in that** the pulse for modulation of the respective currents is chronologically staggered such that in each case only one of the heating elements (2) can be driven simultaneously with a corresponding increase in pulse or decrease in pulse.

6. Electric supplementary heater according to claim 1, **characterised in that** means are provided for influencing the air flow between the opposite window openings (7).

## Revendications

1. Chauffage d'appoint électrique pour le chauffage de l'air de l'habitacle dans des véhicules automobiles, avec :

   plusieurs éléments chauffants (2) rassemblés en un bloc de chauffage, le bloc de chauffage étant maintenu dans un cadre (3, 4, 5) rectangulaire, et le cadre dans lequel est maintenu le bloc de chauffage étant formé de barres longitudinales (3) opposées et de barres latérales (4, 5) disposées perpendiculairement aux barres longitudinales, et

un dispositif de commande (1) pour commander les éléments chauffants (2), qui forme une unité conceptuelle avec le bloc de chauffage maintenu dans le cadre (3, 4, 5), la puissance de chauffage des éléments chauffants (2) étant réglable par le biais du courant traversant respectivement les éléments chauffants (2), et le dispositif de commande (1) comprenant des transistors de puissance (11) pour le réglage du courant traversant respectivement les éléments chauffants (2),

**caractérisé en ce que**,

pour le réglage de la puissance de chauffage, le dispositif de commande (1) module le courant traversant un élément chauffant (2) à l'aide d'une modulation de largeur d'impulsion,

respectivement, seul un des éléments chauffants (2) peut être activé dans le même temps à l'aide d'un accroissement ou d'un abaissement correspondant du courant,

au moins une des barres latérales (5) est constituée sous forme de caisson ouvert d'un côté et dans lequel le dispositif de commande peut être introduit,

des ouvertures en forme de fenêtres (7) sont prévues dans la barre latérale (5) sur les côtés qui sont situés dans le plan superficiel du cadre, et sont disposées de telle sorte qu'elles sont situées dans le flux d'air à chauffer, et

des éléments de refroidissement (6) des transistors de puissance (11) sont placés respectivement entre les ouvertures en forme de fenêtres (7) opposées lorsque le dispositif de commande est introduit.

2. Chauffage d'appoint électrique selon la revendication 1, **caractérisé en ce que** seul le courant traversant un des éléments chauffants (2) peut être modulé, et **en ce que** d'autres éléments chauffants (2) peuvent être respectivement mis en circuit ou mis hors circuit en fonction de la puissance de chauffage à régler.

3. Chauffage d'appoint électrique selon la revendication 1, **caractérisé en ce que** les courants traversant respectivement les éléments chauffants (2) électriques sont modulables en fonction de la puissance de chauffage à régler.

4. Chauffage d'appoint électrique selon la revendication 3, **caractérisé en ce que** l'impulsion qui module les courants traversant les éléments chauffants (2) est respectivement décalée dans le temps de sorte que le courant total résultant des courants traversant les éléments chauffants (2) est le plus constant possible.

5. Chauffage d'appoint électrique selon la revendication 3 ou la revendication 4, **caractérisé en ce que** l'impulsion pour la modulation des courants respectifs est décalée dans le temps de sorte que respectivement seul un des éléments chauffants (2) peut être piloté dans le même temps à l'aide d'un accroissement ou d'un abaissement correspondant des impulsions.

6. Chauffage d'appoint électrique selon la revendication 1, **caractérisé en ce qu'**il est prévu des moyens permettant d'agir sur l'écoulement d'air entre les ouvertures en forme de fenêtres (7) opposées.

FIG. 1a

FIG. 1b

FIG. 2

FIG. 3

FIG. 4

FIG. 8

FIG. 5a

FIG. 5c

FIG. 5b

FIG. 6b

FIG. 6a

FIG. 7a

FIG. 7b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0901311 A2
- EP 0837381 A2
- DE 19845401